# EUROPEAN PATENT APPLICATION

(11) **EP 4 535 505 A2**
(43) Date of publication of application: **09.04.2025**
(21) Application number: 24174568.6
(22) Date of filing: 07.05.2024
(51) Int. Cl.: H01M 10/48, H01M 50/209, H01M 50/298, H01M 50/30, H01M 50/507, H01M 50/284, H05K 1/02, H05K 3/32

(54) **ELECTRONIC ELEMENT ASSEMBLY AND BATTERY MODULE INCLUDING THE SAME**

(30) Priority: 06.10.2023 KR 20230133091
(71) Applicant: Samsung SDI Co., Ltd., Yongin-si, Gyeonggi-do 17084 (KR)
(72) Inventor: Ahn, Jae Pil, 16678 Suwon-si, Gyeonggi-do (KR); Yun, Chul Jung, 16678 Suwon-si, Gyeonggi-do (KR)
(74) Representative: Gulde & Partner

(57) **Abstract**

An electronic element assembly (100) includes: a circuit board (130), an electronic element (140) mounted on the circuit board, a plurality of first connection terminals (150) coupled to the circuit board and configured to be electrically connected to the electronic element, the plurality of first connection terminals being electrically connected to a plurality of first electrical wires (65), and a plurality of second connection terminals (160) coupled to the circuit board and configured to be electrically connected to the electronic element, the plurality of second connection terminals being electrically connected to a plurality of second electrical wires (75) spaced apart from the plurality of first electrical wires.

## Description

### BACKGROUND

### 1. Field of the Invention

Aspects of the present invention are related to an electronic element assembly and a battery module including the same.

### 2. Discussion of Related Art

In general, with rapidly increasing demand for portable electronics, such as laptops, video cameras, and mobile phones, and commercialization of robots and electric vehicles, research is actively carried out to develop high-performance secondary batteries enabling repeated charging/discharging.

Secondary batteries are widely used in small devices, such as portable electronics, as well as medium and large devices, such as electric vehicles and energy storage systems (ESS), for power generation and energy storage. In particular, in medium or large devices, multiple battery cells are electrically connected to each other to form a battery module in order to enhance output and/or capacity of the batteries.

Sensors may be installed on the battery module to detect whether charging and discharging is being performed and working normally, and generally the sensors are electrically connected by a flexible printed circuit (FPC). However, for example, when the number of battery cells increases, it may be more advantageous to use a wire than the FPC to reduce costs. However, as the number of battery cells increases, it is difficult to arrange the wires, the size of the battery module may increase, and it is difficult to connect an electronic element such as a fuse.

The above information disclosed in this Background section is provided for enhancement of understanding of the background of the present invention, and, therefore, it may contain information that does not constitute related (or prior) art.

### SUMMARY OF THE INVENTION

It was an object of the present invention to reduce the size of a battery module, and thus, to reduce the production cost of the battery, and to improve the manufacturing productivity of the battery module.

The present invention is set out in the appended set of claims, wherein the drawings and respective description relate to advantageous embodiments thereof.

Aspects of the present invention are directed to providing an electronic element assembly in which electronic elements and electrical wires can be easily connected, and a plurality of electrical wires can be neatly arranged, and a battery module including the same. These and other aspects and features of the present invention will be described in or will be apparent from the following description of some embodiments of the present invention.

According to some embodiments of the present invention to solve the technical problems, there is provided an electronic element assembly including a circuit board, an electronic element mounted on the circuit board, a plurality of first connection terminals coupled to the circuit board and configures to be electrically connected to the electronic element, the plurality of first connection terminals being electrically connected to a plurality of first electrical wires, and a plurality of second connection terminals coupled to the circuit board and configures to be electrically connected to the electronic element, and electrically connected to a plurality of second electrical wires spaced apart from the plurality of first electrical wires.

In some embodiments, the electronic element assembly further includes a case configures to accommodate the circuit board, the electronic element, the plurality of first connection terminals, and the plurality of second connection terminals, the case having a plurality of electrical wire entry holes formed therein and into which ends of the plurality of first electrical wires and ends of the plurality of second electrical wires are configures to be inserted.

In some embodiments, the case includes a base having the plurality of the electrical wire entry holes formed therein, and a cover detachably coupled to the base and configures to cover the circuit board, the electronic element, the plurality of first connection terminals, and the plurality of second connection terminals.

In some embodiments, the cover includes a circuit board pusher configured to press the circuit board such that the plurality of first connection terminals are connected to the plurality of first electrical wires and the plurality of second connection terminals are connected to the plurality of second electrical wires.

In some embodiments, the cover includes a circuit board support protrusion configured to support the circuit board such that the circuit board is not separated from the cover.

In some embodiments, one of the base and the cover includes a hook receiver, and the other of the base and the cover includes a hook detachably coupled to the hook receiver.

In some embodiments, each of the first electrical wire and the second electrical wire includes a core formed of a conductor configures to conduct current and a sheath formed of an insulator and surrounding the core, and each of the first connection terminal and the second connection terminal includes a fork configures to cut the sheath and to electrically coming into contact with the core.

In some embodiments, the electronic element is mounted on one side surface of the circuit board, and the fork protrudes from the other side surface of the circuit board.

In some embodiments, the electronic element includes a plurality of fuses configures to be connected to the plurality of first connection terminals and the plurality of second connection terminals.

According to some embodiments of the present invention to solve the technical problems, there is provided a battery module including a plurality of battery cells, a plurality of sensors configured to detect a state of the plurality of battery cells, a plurality of first electrical wires electrically connected to the plurality of sensors, a plurality of second electrical wires spaced apart from the plurality of first electrical wires and electrically connected to a connector, and an electronic element assembly configured to electrically connect the plurality of first electrical wires and the plurality of second electrical wires and including a circuit board, an electronic element mounted on the circuit board, a plurality of first connection terminals coupled to the circuit board and configures to be electrically connected to the electronic element and the plurality of first electrical wires, and a plurality of second connection terminals coupled to the circuit board and configured to be electrically connected to the electronic element and the plurality of second electrical wires.

In some embodiments, the electronic element assembly further includes a case configures to accommodate the circuit board, the electronic element, the plurality of first connection terminals, and the plurality of second connection terminals, the case having a plurality of electrical wire entry holes formed therein and into which ends of the plurality of first electrical wires and ends of the plurality of second electrical wires are configures to be inserted.

In some embodiments, the case includes a base having the plurality of the electrical wire entry holes formed therein, and a cover detachably coupled to the base and covering the circuit board, the electronic element, the plurality of first connection terminals, and the plurality of second connection terminals.

In some embodiments, the cover includes a circuit board pusher configured to press the circuit board such that the plurality of first connection terminals are connected to the plurality of first electrical wires and the plurality of second connection terminals are connected to the plurality of second electrical wires.

In some embodiments, each of the first electrical wire and the second electrical wire includes a core formed of a conductor configured to conduct current and a sheath formed of an insulator and surrounding the core, and each of the first connection terminal and the second connection terminal includes a fork configures to cut the sheath and to electrically coming into contact with the core.

In some embodiments, the electronic element is mounted on one side surface of the circuit board, and the fork protrudes from the other side surface of the circuit board.

In some embodiments, the electronic element is a plurality of fuses to be connected to the plurality of first connection terminals and the plurality of second connection terminals.

In some embodiments, the battery module further includes a cell connection busbar configured to electrically connect a neighboring pair of battery cells of the plurality of battery cells, and a busbar holder configured to support the cell connection busbar and on which the electronic element assembly is installed.

In some embodiments, each of the battery cells includes a cell vent through which gas is discharged from an inside of the battery cell to an outside of the battery cell, wherein the busbar holder has a plurality of vent through-holes corresponding to the plurality of cell vents formed therein, and wherein the electronic element assembly is positioned between a neighboring pair of vent through-holes of the plurality of the vent through-holes.

In some embodiments, the sensor includes a voltage sensor that is electrically connected to the cell connection busbar and is configures to measure a voltage.

In some embodiments, the battery module further includes a wire holder in which a plurality of wire fitting grooves are formed, the plurality of first electrical wires being configures to fit within and be and supported by the wire fitting grooves, the wire holder being on the busbar holder.

According to some embodiments of the present invention, when sensors included in a battery module are connected to a connector with a plurality of electrical wires, for example, an electronic element such as a fuse can be easily and quickly connected to the electrical wires.

According to some embodiments of the present invention, because an electronic element and electrical wires in the battery module are neatly arranged without bunching or tangling, it is easy to reduce (e.g., minimize) the size of the battery module, the production cost of the battery module can be reduced, and the manufacturing productivity of the battery module can be improved (e.g., increased).

However, the effects obtainable through the present invention are not limited to the above effects, and other technical effects that are not mentioned will be clearly understood by those skilled in the art from the following description of the present invention.

### BRIEF DESCRIPTION OF THE DRAWINGS

The drawings attached to this specification illustrate some embodiments of the present invention, and further describe aspects and features of the present invention together with the detailed description of the present invention. However, the present invention should not be construed as being limited to the drawings:
FIG. 1 is an exploded perspective view of a battery module according to some embodiments of the present invention;
FIG. 2 is a perspective view illustrating a busbar holder in FIG. 1 and elements mounted on the busbar holder, according to some embodiments of the present invention;
FIG. 3 is an enlarged perspective view of the portion III in FIG. 2, according to some embodiments of the present invention;
FIG. 4 is an exploded perspective view of an electronic element assembly in FIG. 3, as viewed from above, according to some embodiments of the present invention;
FIG. 5 is an exploded perspective view of the electronic element assembly in FIG. 3, as viewed from below, according to some embodiments of the present invention;
FIG. 6 is an enlarged view of the portion VI in FIG. 4, according to some embodiments of the present invention;
FIG. 7 is an enlarged view of the portion VII in FIG. 4, according to some embodiments of the present invention;
FIG. 8 is a cross-sectional view taken along the line VIII-VIII in FIG. 3, according to some embodiments of the present invention;
FIG. 9 is a cross-sectional view taken along the line IX-IX in FIG. 4, according to some embodiments of the present invention;
FIG. 10 is a cross-sectional view taken along the line X-X in FIG. 4, according to some embodiments of the present invention;
FIG. 11 is a perspective view illustrating a wire holder in FIG. 3 and electrical wires supported on the wire holder; and
FIG. 12 is a view illustrating the wire holder in FIG. 11 separated from the electrical wires, according to some embodiments of the present invention.

### DETAILED DESCRIPTION OF EXEMPLARY EMBODIMENTS

Hereinafter, embodiments of the present invention will be described, in detail, with reference to the accompanying drawings. The terms or words used in this specification and claims should not be construed as being limited to the usual or dictionary meaning and should be interpreted as meaning and concept consistent with the technical idea of the present invention based on the principle that the inventor can be his/her own lexicographer to appropriately define the concept of the term to explain his/her invention in the best way.

The embodiments described in this specification and the configurations shown in the drawings are only some of the embodiments of the present invention and do not represent all of the technical ideas, aspects, and features of the present invention. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present invention relates to "one or more embodiments of the present invention." Expressions, such as "at least one of' and "any one of," when preceding a list of elements, modify the entire list of elements and do not modify the individual elements of the list. When phrases such as "at least one of A, B and C," "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention and is not intended to be limiting of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

A battery pack according to some embodiments includes at least one battery module and a pack housing having an accommodation space in which the at least one battery module is accommodated.

The battery module may include a plurality of battery cells and a module housing. The battery cells may be accommodated inside the module housing in a stacked form (or stacked arrangement or configuration). Each battery cell may have a positive electrode terminal and a negative electrode terminal and may be a circular type, a prismatic type, or a pouch type according to the shape of battery. Herein, a battery cell may also be referred to as a secondary battery, a battery, or a cell.

In the battery pack, one cell stack may constitute one module stacked in place of the battery module. The cell stack may be accommodated in an accommodation space of the pack housing or may be accommodated in an accommodation space partitioned by a frame, a partition wall, or the like.

The battery cell may generate a large amount of heat during charging/discharging. The generated heat may be accumulated in the battery cell, thereby accelerating the deterioration of the battery cell. Accordingly, the battery pack may further include a cooling member to remove the generated heat and thereby suppress deterioration of the battery cell. The cooling member may be provided at the bottom of the accommodation space where the battery cell is provided but is not limited thereto and may be provided at the top or side depending on the battery pack.

The battery cell may be configured such that exhaust gas generated inside the battery cell under abnormal operating conditions, also known as thermal runaway or thermal events, is discharged to the outside of the battery cell. The battery pack or the battery module may include an exhaust port for discharging the exhaust gas to prevent or reduce damage to the battery pack or module by the exhaust gas.

The battery pack may include a battery and a battery management system (BMS) for managing the battery. The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., voltage, current, temperature, or the like) to output state information indicating the state of the battery. The detection device may detect the voltage of each cell constituting the battery or of each battery module. The detection device may detect current flowing through each battery module constituting the battery module or the battery pack. The detection device may also detect the temperature of a cell and/or module on at least one point of the battery and/or an ambient temperature.

The balancing device may perform a balancing operation of a battery module and/or cells constituting the battery module. The control device may receive state information (e.g., voltage, current, temperature, or the like) of the battery module from the detection device. The control device may monitor and calculate the state of the battery module (e.g., voltage, current, temperature, state of charge (SOC), life span (state of health (SOH)), or the like) on the basis of the state information received from the detection device. In addition, on the basis of the monitored state information, the control device may perform a control function (e.g., temperature control, balancing control, charge/discharge control, etc.) and a protection function (e.g., over-discharge, over-charge, over-current protection, short circuit, fire extinguishing function, or the like). In addition, the control device may perform a wired or wireless communication function with an external device of the battery pack (e.g., a higher level controller or vehicle, charger, power conversion system, or the like).

The control device may control the charging/discharging operation and protection operation of the battery. To this end, the control device may include a charge/discharge controller (e.g., charge/discharge control unit), a balancing controller (balancing control unit), and/or a protection circuit (e.g., a protection unit).

The battery management system is a system that monitors the battery state and performs diagnosis and control, communication, and protection functions, and may calculate the charge/discharge state, calculate battery life or state of health (SOH), cut off, as desired, battery power (e.g., relay control), control thermal management (e.g., cooling, heating, or the like), perform a high-voltage interlock function, and/or may detect and/or calculate insulation and short circuit conditions.

A relay may be a mechanical contactor that is turned on and off by the magnetic force of a coil or a semiconductor switch, such as a metal oxide semiconductor field effect transistor (MOSFET).

The relay control has a function of cutting off the power supply from the battery if (or when) a problem occurs in the vehicle and the battery system and may include one or more relays and pre-charge relays at the positive terminal and the negative terminal, respectively.

In the pre-charge control, there is a risk of inrush current occurring in the high-voltage capacitor on the input side of the inverter when the battery load is connected. Thus, to prevent or reduce inrush current when starting a vehicle, the pre-charge relay may be operated before connecting the main relay and the pre-charge resistor may be connected.

The high-voltage interlock is a circuit that uses a small signal to detect whether or not all high-voltage parts of the entire vehicle system are connected and may have a function of forcibly opening a relay if (or when) an opening occurs at even one location on the entire loop.

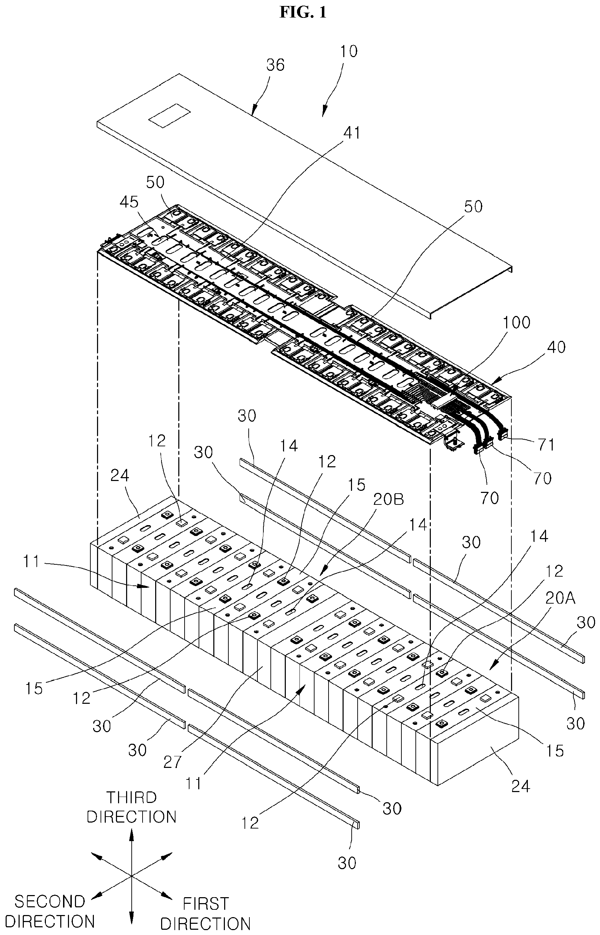

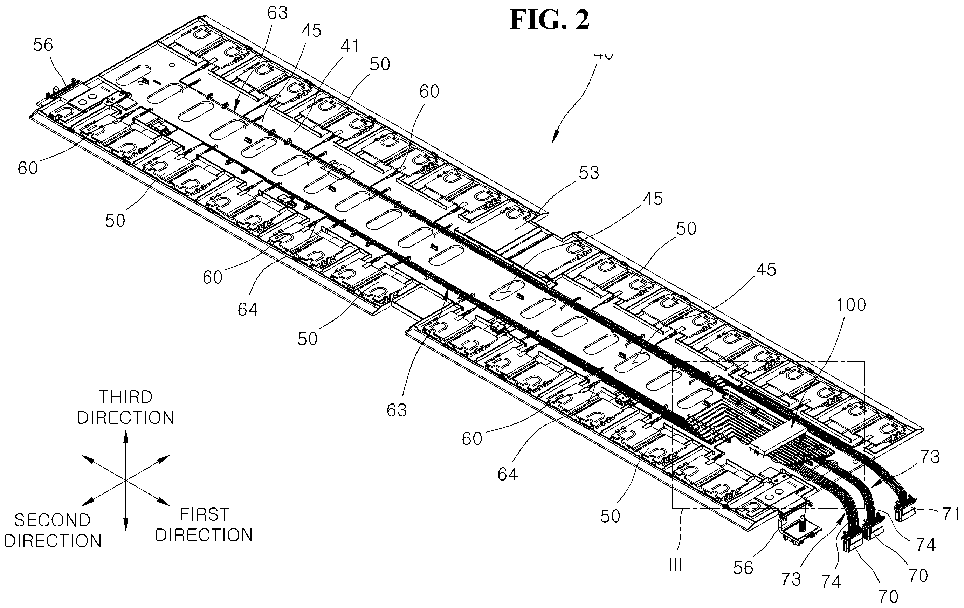

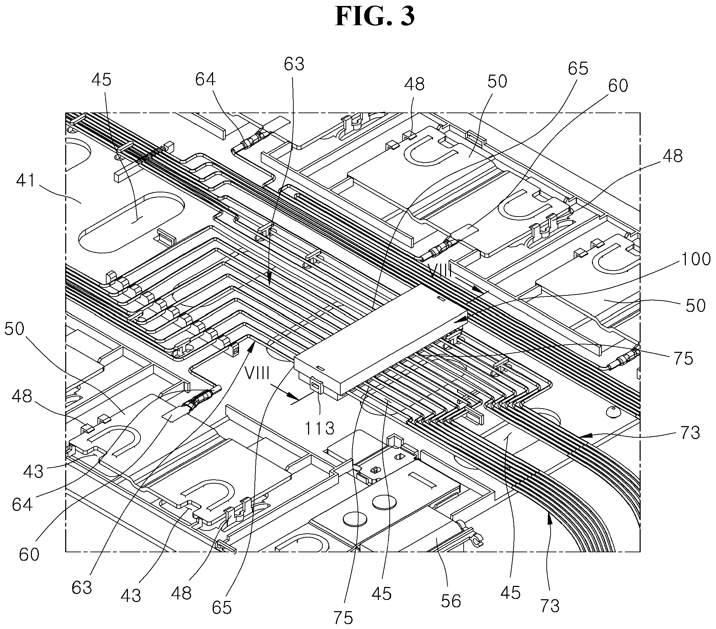

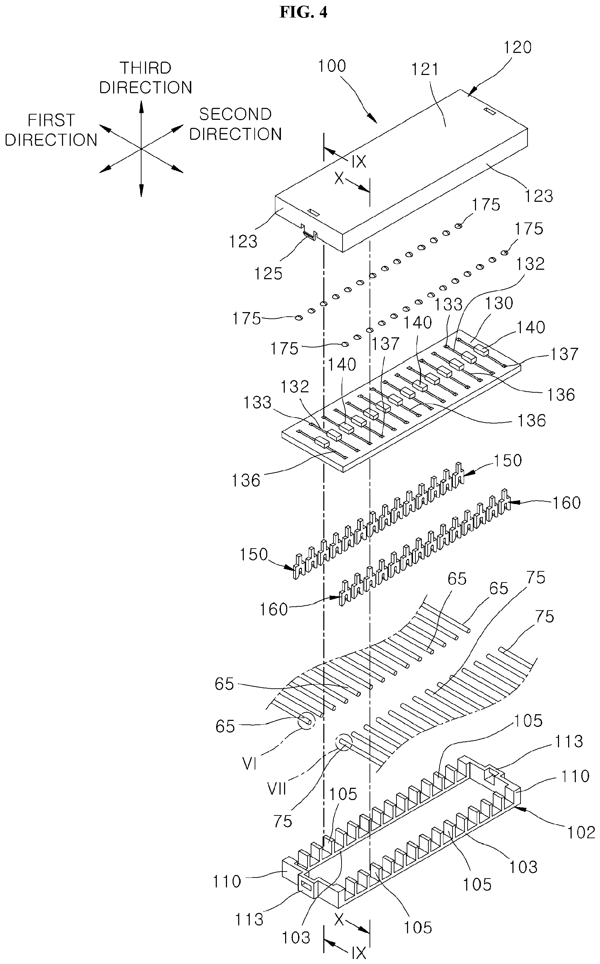

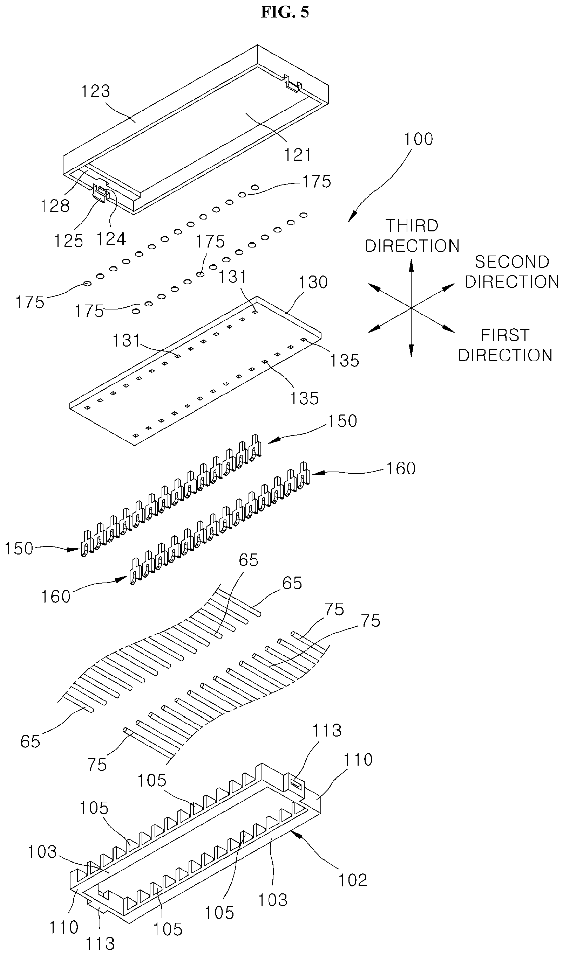

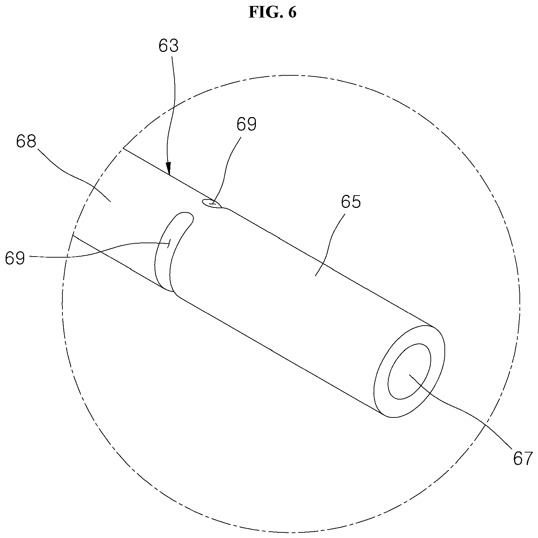

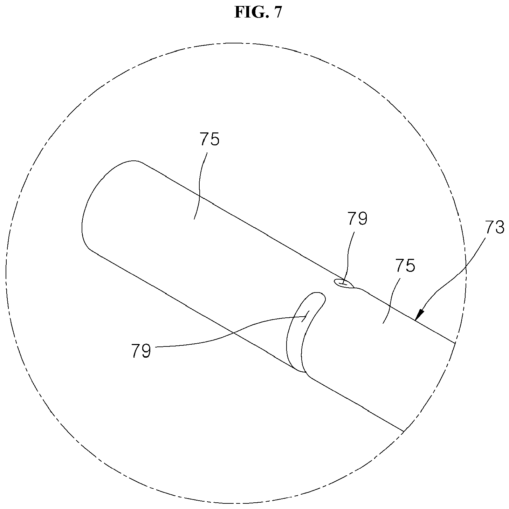

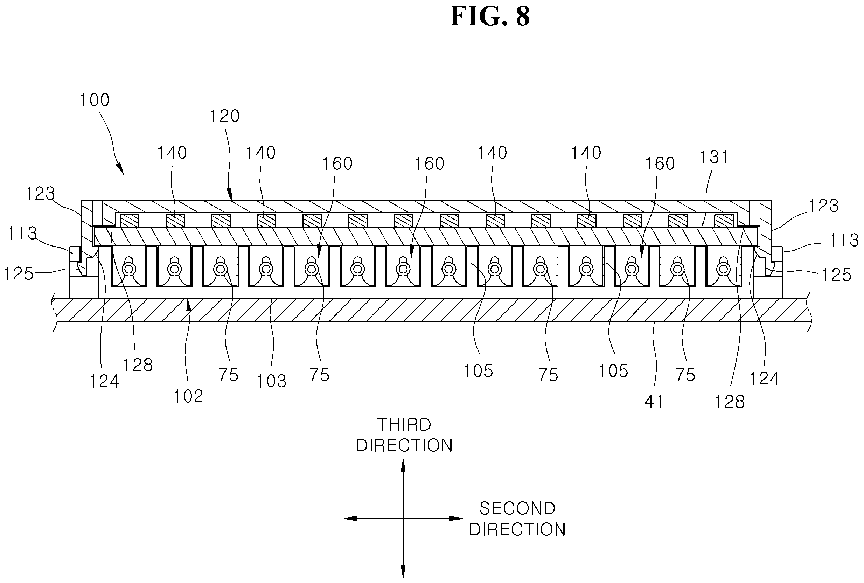

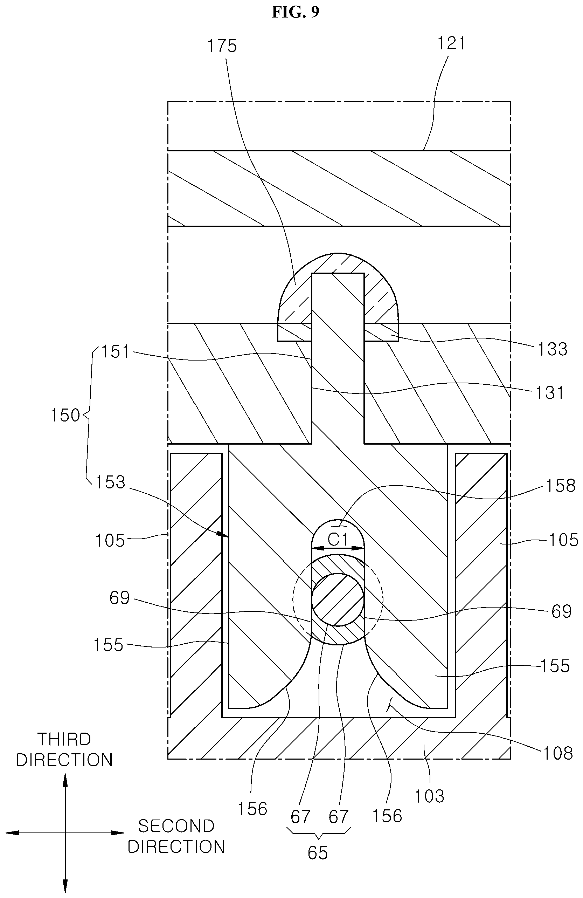

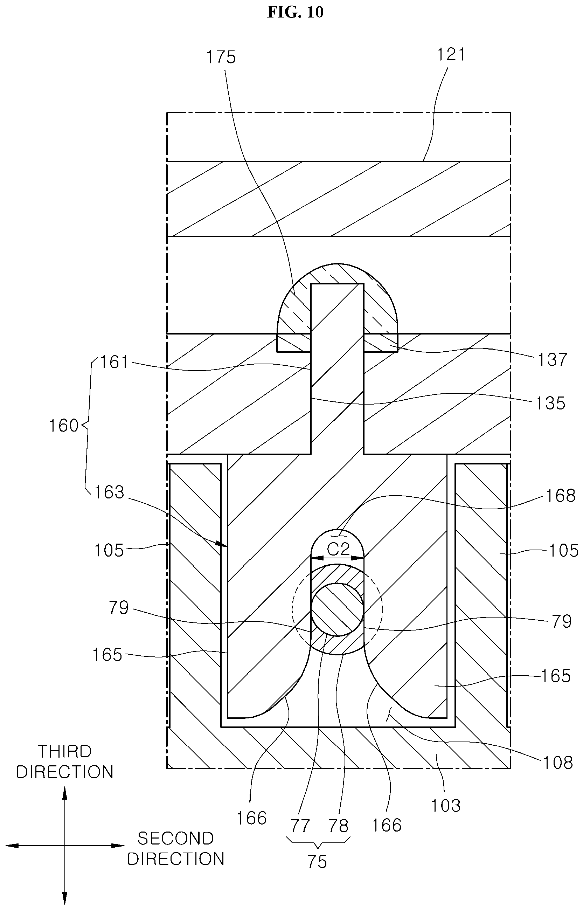

FIG. 1 is an exploded perspective view of a battery module according to some embodiments of the present invention, FIG. 2 is a perspective view illustrating a busbar holder in FIG. 1 and elements mounted on the busbar holder, according to some embodiments of the present invention, FIG. 3 is an enlarged perspective view of the portion III in FIG. 2, according to some embodiments of the present invention, FIG. 4 is an exploded perspective view of an electronic element assembly in FIG. 3, as viewed from above, according to some embodiments of the present invention, FIG. 5 is an exploded perspective view of the electronic element assembly in FIG. 3, as viewed from below, according to some embodiments of the present invention, FIG. 6 is an enlarged view of the portion VI in FIG. 4, according to some embodiments of the present invention, FIG. 7 is an enlarged view of the portion VII in FIG. 4, according to some embodiments of the present invention, FIG. 8 is a cross-sectional view taken along line VIII-VIII in FIG. 3, according to some embodiments of the present invention, FIG. 9 is a cross-sectional view taken along line IX-IX in FIG. 4, according to some embodiments of the present invention, and FIG. 10 is a cross-sectional view taken along line X-X in FIG. 4, according to some embodiments of the present invention.

With reference to FIGS. 1 to 10, a battery module 10 according to some embodiments of the present invention include a plurality of battery cells 11, a plurality of sensors 60, a plurality of first electrical wires 63, a plurality of second electrical wires 73, and an electronic element assembly 100. The battery cell 11 functions as a unit structure that stores and supplies power in the battery module 10.

The battery cell 11 may be exemplified as a prismatic secondary battery capable of charging and discharging a set or predetermined amount of power by providing an electrode assembly therein, in which a positive electrode plate and a negative electrode plate are disposed on both sides of a separator interposed therebetween.

For example, each battery cell 11 may include a cell body having a substantially cuboidal shape, and a pair of terminals 12 protruding upward from the cell body. In the pair of terminals 12, one may be a positive electrode terminal and the other may be a negative electrode terminal.

The cell body may include a can having an inner space in which the electrode assembly is accommodated and a cap plate closing an open upper side of the can. The pair of terminals 12 may be installed on the cap plate. The battery cell 11 may include a cell vent 14 through which flammable materials and gases generated internally due to abnormalities are discharged from the inside of the battery cell 11 to the outside of the battery cell 11 during the process of charging and discharging. The cell vent 14 may be formed between the pair of terminals 12 on the cap plate.

Hereinafter, a direction parallel to a thickness direction of the battery cell 11, i.e., the can, (or a direction along with the battery cells are stacked) is referred to as a first direction, a direction parallel to a width direction of the battery cell 11 is referred to as a second direction, and a direction parallel to a height direction of the battery cell 11 is referred to as a third direction. The first direction may also be referred to as a front-rear direction, the second direction may also be referred to as a left-right direction, and the third direction may also be referred to as an up-down direction.

In each battery cell 11, a side surface having the pair of terminals 12 protruding to one side along the third direction is referred to as a terminal side surface 15, and a side surface opposite the terminal side surface 15 along the third direction is referred to as a bottom surface.

The plurality of battery cells 11 are arranged in the first direction. The plurality of battery cells 11 may be arranged in a row such that rear and front surfaces of any neighboring pair of battery cells 11 face each other. The plurality of battery cells 11 arranged in a row along the first direction may be referred to as a battery cell stack 20A or 20B.

The battery module 10 of the embodiments illustrated in FIG. 1 includes a first battery cell stack 20A and a second battery cell stack 20B, each having eleven battery cells 11 arranged in a row in the so-called first direction, which may be referred to as a "long module." Therefore, the battery module 10 may include a total of 22 battery cells 11. However, the structure and number of battery cells 11 illustrated in FIG. 1 are exemplary and the present invention is not limited to the example of FIG. 1.

The battery module 10 may further include a pair of end plates 24, a middle plate 27, and a plurality of side beams 30. One of the pair of end plates 24 is disposed in front of the plurality of battery cells 11 so as to cover a front surface of the foremost battery cell 11 along the first direction among the plurality of battery cells 11, and may be referred to as a front plate.

The other of the pair of end plates 24 is disposed at a rear of the plurality of battery cells 11 so as to cover a rear surface of the rearmost battery cell 11 along the first direction, and may be referred to as a rear plate. The middle plate 27 may be interposed between the first battery cell stack 20A and the second battery cell stack 20B.

The plurality of side beams 30 may extend along the first direction. Some side beams 30 of the plurality of side beams 30 may extend along the first direction to face a left side surface of a pair of side surfaces of the plurality of battery cells 11 belonging to the first battery cell stack 20A. Some side beams 30 extending in a longitudinal direction may have one end fixed to the front plate 24, and another end fixed to the middle plate 27.

Some of the other side beams 30 of the plurality of side beams 30 may extend along the first direction to face a right side surface of a pair of side surfaces of the plurality of battery cells 11 belonging to the first battery cell stack 20A. Some of the other side beams 30 extending in the longitudinal direction may have one end fixed to the front plate 24 and another end fixed to the middle plate 27.

Still other ones of the side beams 30 may extend along the first direction to face a left side surface of a pair of side surfaces of the plurality of battery cells 11 belonging to the second battery cell stack 20B. Such side beams 30 may have one end fixed to the middle plate 27 and another end fixed to the rear plate 24.

The remaining side beams 30 may extend along the first direction to face a right side surface of a pair of side surfaces of the plurality of battery cells 11 belonging to the second battery cell stack 20B. The remaining side beams 30 may have one end fixed to the middle plate 27 and another end fixed to the rear plate 24.

In some examples, unlike that illustrated in FIG. 1, the battery module 10 may also include a plurality of side plates instead of the plurality of side beams 30.

The battery module 10 may further include a bottom plate that covers bottom surfaces of the plurality of battery cells 11 and supports the plurality of battery cells 11. The bottom plate may be fixedly coupled to the pair of end plates 24 and the middle plate 27.

The battery module 10 may further include a plurality of cell connection busbars 50 and a busbar holder 40. Each cell connection busbar 50 may electrically connect a neighboring pair of battery cells 11. For example, the positive electrode terminal 12 in one battery cell 11 and the negative electrode terminal 12 in the other battery cell 11 in the pair of neighboring battery cells 11 along the first direction may be connected by the cell connection busbar 50. The cell connection busbar 50 may be bonded to the positive electrode terminal 12 or the negative electrode terminal 12 by welding.

The battery module 10 may further include a pair of module connection busbars 56 and one intermediate connection busbar 53. The pair of module connection busbars 56 are provided for electrically connecting the battery module 10 to other neighboring battery modules.

One end of each of the pair of module connection busbars 56 may be connected to the terminals 12 positioned at both ends of the first direction of the battery module 10 along the first direction. The other end of each of the pair of module connection busbars 56 may be connected to a connection terminal provided on the end plate 24.

The intermediate connection busbar 53 may connect the terminal 12 of one battery cell 11 to the terminal 12 of the other battery cell 11 in the pair of battery cells disposed in front of and behind the middle plate with the middle plate 27 interposed therebetween along the first direction.

The busbar holder 40 supports the plurality of cell connection busbars 50, the pair of module connection busbars 56, and the intermediate connection busbar 53. The busbar holder 40 may be disposed to cover the terminal side surfaces 15 of the plurality of battery cells 11.

The busbar holder 40 may include a holder plate 41 having a substantially flat plate shape. The busbar holder 40 may further include a plurality of busbar fixing brackets 48. The busbars 50, 53, and 56 may be detachably fixed to the holder plate 41 by the plurality of busbar fixing brackets 48.

A plurality of terminal connection through-holes 43 may be formed in the holder plate 41 so that the busbars 50, 53, and 56 are connected to the terminals 12 of the plurality of battery cells 11. A plurality of vent through-holes 45 corresponding to the plurality of cell vents 14 may be formed in the busbar holder 40.

For example, the plurality of vent through-holes 45 may be formed at positions that are aligned in the third direction with the plurality of cell vents 14 and formed to pass through the holder plate 41 in the third direction. Accordingly, flammable materials and gases that are ejected from any one of the plurality of cell vents 14 to the outside of the battery cell 11 may be discharged to the outside of the plurality of battery cells 11 without being blocked by the busbar holder 40 and returning to the plurality of battery cells 11.

The battery module 10 may further include a module cover 36 that covers the busbar holder 40 such that the busbars 50, 53, and 56 installed in the busbar holder 40 are not exposed. The busbar holder 40 and the module cover 36 may be fixedly coupled to the pair of end plates 24 and the middle plate 27. Alternatively, the busbar holder 40 may be fixedly coupled to the pair of end plates 24 and the middle plate 27, and the module cover 36 may be fixedly coupled to the busbar holder 40.

The plurality of sensors 60 detect the state of the plurality of battery cells 11 during charging and discharging of the battery module 10. The plurality of sensors 60 may be, for example, voltage sensors electrically connected to the plurality of cell connection busbars 50 to measure a voltage. The battery module 10 may further include, for example, a plurality of temperature sensors that measure the temperature of various portions of the battery module 10.

The plurality of first electrical wires 63 are electrically connected to the plurality of sensors 60. One end 64 of the first electrical wire 63 may be connected to the sensor 60, and the other end 65 of the first electrical wire 63 may be connected to the electronic element assembly 100.

The plurality of second electrical wires 73 are spaced apart from the plurality of first electrical wires 63 and electrically connected to a connector 70. One end 74 of the second electrical wire 73 may be connected to the connector 70, and the other end 75 of the second electrical wire 73 may be connected to the electronic element assembly 100.

The connector 70 may be detachably coupled to a controller connector that is electrically connected to a battery pack controller, which controls a battery pack including the battery module 10. When the connector 70 and the controller connector are coupled, the plurality of sensors 60 and the battery pack controller are connected to enable communication of electrical signals. Accordingly, the battery pack controller may identify the state of the battery module 10.

The electronic element assembly 100 electrically connects the plurality of first electrical wires 63 and the plurality of second electrical wires 73. The plurality of first electrical wires 63 and the plurality of second electrical wires 73 may be connected (e.g., connected one-to-one) by the electronic element assembly 100.

In some examples, some sensors 60 included in the battery module 10 may be connected to a connector 71 that is different from the connector 70, which is connected to the second electrical wire 73 through another electrical wire instead of the first electrical wire 63 and the second electrical wire 73. In other words, some sensors 60 may be connected to the connector 71 without being connected to the electronic element assembly 100.

The electronic element assembly 100 includes a circuit board 130, an electronic element 140, a plurality of first connection terminals 150, and a plurality of second connection terminals 160. The electronic element assembly 100 may be installed on the busbar holder 40. The electronic element assembly 100 may be positioned between a neighboring pair of vent through-holes 45 so as not to interfere with gas discharge through the cell vent 14.

To reduce (e.g., minimize) a total length of the plurality of first electrical wires 63 and the plurality of second electrical wires 73 disposed in the busbar holder 40, the electronic element assembly 100 may be positioned at an end closer to the connector 70 of two ends of the busbar holder 40 along the first direction.

The electronic element 140 is mounted on the circuit board 130. The electronic element 140 may be, for example, a fuse that melts and blows when an overcurrent flows along the first electrical wire 63 and the second electrical wire 73. However, the fuse is exemplary, and the electronic element assembly 100 according to some other embodiments of the present invention include a different type of electronic element, such as a capacitor, for example.

The number of first electrical wires 63 connected to the electronic element assembly 100 may be the same as the number of second electrical wires 73 connected to the electronic element assembly 100. There may be a plurality of electronic elements 140. In the electronic element assembly 100 according to some embodiments of the present invention, the number of electronic elements 140 is provided in the same number as the number of first electrical wires 63 and the number of second electrical wires 73.

The electronic element 140 may be mounted on one side surface of the circuit board 130. The circuit board 130 included in the battery module 10 according to some embodiments of the present invention includes a side surface that faces the plurality of battery cells 11 and an opposite side surface along the third direction, and the electronic element 140 may be mounted on the side surface opposite to the side surface facing the plurality of battery cells 11. Hereinafter, the side surface facing the battery cell 11 may be referred to as a bottom surface of the circuit board 130, and a side surface opposite to the bottom surface of the circuit board 130 may be referred to as a top surface of the circuit board 130. According to some embodiments, the electronic element 140 may be mounted on one side surface of the circuit board 130, and the fork 153, 163 may protrude from the other side surface of the circuit board 130.

The plurality of first connection terminals 150 are formed of a conductor and coupled to the circuit board 130 to be electrically connected to the electronic element 140. When the circuit board 130 approaches the plurality of first electrical wires 63, the plurality of first connection terminals 150 are electrically connected to the plurality of first electrical wires 63. The number of first connection terminals 150 may be equal to the number of first electrical wires 63 that are connected to the electronic element assembly 100.

The plurality of second connection terminals 160 are formed of a conductor and coupled to the circuit board 130 to be electrically connected to the electronic element 140. When the circuit board 130 approaches the plurality of second electrical wires 63, the plurality of second connection terminals 160 are electrically connected to the plurality of second electrical wires 63. The number of second connection terminals 160 may be equal to the number of second electrical wires 73 that are connected to the electronic element assembly 100.

Each of the first electrical wires 63 may include a core 67 formed of a conductor to allow current to flow and a sheath 68 formed of an insulator and surrounding the core 67. Each of the first connection terminals 150 may include a pin 151 and a fork 153. The fork 153 may cut the sheath 68 of the first electrical wire 63 and electrically come into contact with the core 67.

The fork 153 may protrude from a side surface opposite to the side surface of the circuit board 130 on which the electronic element 140 is mounted, that is, from the bottom surface of the circuit board 130. The fork 153 includes a pair of branched portions 155 that protrude downward and are spaced apart from each other. Blades 156 capable of cutting the sheath 68 may be formed on facing surfaces of the pair of branched portions 155.

The pair of blades 156 may be tapered so that a gap therebetween increases in a downward direction (e.g., in a direction toward a base 102). A narrow groove 158 may be formed at an upper end of the pair of blades 156. The maximum width C1 of the narrow groove 158 is smaller than the diameter of the first electrical wire 63 and may be equal to or slightly smaller than the diameter of the core 67.

During installation, when the circuit board 130 approaches the first electrical wire 63 along the third direction with the first electrical wire 63 and the first connection terminal 150 aligned along the third direction, that is, when the circuit board 130 advances downward, the first electrical wire 63 may enter between lower ends of the tapered pair of branched portions 155.

As the circuit board 130 advances further downward along the third direction, the first electrical wire 63 may enter the narrow groove 158 and the sheath 68 may be cut by the pair of blades 156 to form a slit 69. An outer circumferential surface of the core 67 and the pair of branched portions 155 may be electrically connected by the slit 69.

The pin 151 may extend along the third direction to pass through the circuit board 130 along the third direction. Alower end of the pin 151 may be connected to the fork 153, and an upper end of the pin 151 may protrude from the top surface of the circuit board 130. A plurality of first through-holes 131 through which the pins 151 of the plurality of first connection terminals 150 pass may be formed in the circuit board 130.

A plurality of first conductive layers 132 electrically connecting the electronic element 140 and the plurality of first through-holes 131 may be formed on the top surface of the circuit board 130. In the battery module 10 according to some embodiments of the present invention, the number of electronic elements 140 is the same as the number of first connection terminals 150, and one side of each first conductive layer 132 is connected to one pin 151 and the other side is connected to one electronic element 140.

As illustrated in FIG. 9, one end of the first conductive layer 132 has a soldering terminal 133 around the first through-hole 131, and a solder 175 may be bonded to cover an upper end of the pin 151 and the soldering terminal 133 such that the pin 151 and the first conductive layer 132 may be electrically connected.

Each of the second electrical wires 73 may include a core 77 formed of a conductor to allow current to flow, and a sheath 78 formed of an insulator and surrounding the core 77. Each of the second connection terminals 160 may include a pin 161 and a fork 163. The fork 163 is configured to cut the sheath 78 of the second electrical wire 73 and electrically come into contact with the core 77.

The fork 163 may protrude from a side surface opposite to a side surface of the circuit board 130 on which the electronic element 140 is mounted, that is, from the bottom surface of the circuit board 130. The fork 163 includes a pair of branched portions 165 that protrude downward and are spaced apart from each other. Blades 166 capable of cutting the sheath 78 may be formed on facing surfaces of the pair of branched portions 165.

The pair of blades 166 may be tapered so that a gap therebetween increases in a downward direction (e.g., in a direction toward a base 102). A narrow groove 168 may be formed at an upper end of the pair of blades 166. The maximum width C2 of the narrow groove 168 is smaller than the diameter of the second electrical wire 73 and may be equal to or slightly smaller than the diameter of the core 77.

During installation, when the circuit board 130 approaches the second electrical wire 73 along the third direction with the second electrical wire 73 and the second connection terminal 160 aligned along the third direction, that is, when the circuit board 130 advances downward, the second electrical wire 73 may enter between lower ends of the tapered pair of branched portions 165.

As the circuit board 130 advances further downward along the third direction, the second electrical wire 73 may enter the narrow groove 168 and the sheath 78 may be cut by the pair of blades 166 to form a slit 79. An outer circumferential surface of the core 77 and the pair of branched portions 165 may be electrically connected by the slit 79.

The pin 161 may extend along the third direction to pass through the circuit board 130 along the third direction. A lower end of the pin 161 may be connected to the fork 163, and an upper end of the pin 161 may protrude from the top surface of the circuit board 130. A plurality of second through-holes 135 through which the pins 161 of the plurality of second connection terminals 160 pass may be formed in the circuit board 130.

A plurality of second conductive layers 136 electrically connecting the electronic element 140 and the plurality of second through-holes 135 may be formed on the top surface of the circuit board 130. In the battery module 10 according to some embodiments of the present invention, the number of electronic elements 140 is the same as the number of second connection terminals 160, and one side of each second conductive layer 136 is connected to one pin 161 and the other side is connected to one electronic element 140.

As illustrated in FIG. 10, one end of the second conductive layer 136 has a soldering terminal 137 around the second through-hole 135, and a solder 175 may be bonded to cover an upper end of the pin 161 and the soldering terminal 137 such that the pin 161 and the second conductive layer 136 may be electrically connected.

The plurality of electronic elements 140 may be disposed in a central portion of the circuit board 130 along the first direction, the plurality of first conductive layers 132 may be disposed on one side of the electronic element 140 closer to the first electrical wire 63 than the second electrical wire 73, and the plurality of second conductive layers 136 may be disposed on the other side of the electronic element 140 closer to the second electrical wire 73 than the first electrical wire 63.

The electronic element assembly 100 may further include a case. The case accommodates the circuit board 130, the plurality of electronic elements 140, the plurality of first connection terminals 150, and the plurality of second connection terminals 160 therein. A plurality of electrical wire entry holes 108 into which the other ends 65 of the plurality of first electrical wires 63 and the other ends 75 of the plurality of second electrical wires 73 are inserted are formed in the case.

The case may include a base 102 and a cover 120 detachably coupled to the base 102. The base 102 may be fixedly supported between a neighboring pair of vent through-holes 45 among the plurality of vent through-holes 45 formed in the holder plate 41. The plurality of electrical wire entry holes 108 may be formed in the base 102.

The base 102 may include a plurality of partition walls 105 spaced apart along the second direction, and a partition wall connection plate 103 connecting the plurality of partition walls 105 and supported on the holder plate 41. The plurality of partition walls 105 may be arranged along two lines.

During installation, between the plurality of partition walls 105 arranged along one line of the two lines, the ends 65 of the first electrical wires 63 may be fitted one by one, and the forks 153 of the plurality of first connection terminals 150 may be inserted one by one (i.e., the forks 153 may be coupled one-to-one to the ends 65 of the first electrical wires 63). Between the plurality of partition walls 105 arranged along the other line of the two lines, the ends 75 of the second electrical wires 73 may be fitted one by one, and the forks 163 of the plurality of second connection terminals 160 may be inserted one by one (i.e., the forks 163 may be coupled one-to-one to the ends 75 of the second electrical wires 73).

Between a neighboring pair of partition walls 105 of the plurality of partition walls 105, the electrical wire entry hole 108 may be formed into which the end 65 of the first electrical wire 63 and the fork 153 of the first connection terminal 150 are inserted, or the end 75 of the second electrical wire 73 and the fork 163 of the second connection terminal 160 are inserted. The base 102 may further include a pair of sidewalls 110 at both ends thereof along the second direction.

The cover 120 may include a top plate 121, a skirt 123, a circuit board pusher 128, and a circuit board support protrusion 124. The top plate 121 may cover and prevent the circuit board 130, the plurality of electronic elements 140, the plurality of first connection terminals 150, and the plurality of second connection terminals 160 from being exposed to the outside. In an embodiment, the cover 120 may include a circuit board support protrusion 124 configured to support the circuit board 130 such that the circuit board 130 is not separated from the cover 120.

The skirt 123 is a portion of the top plate 121 that is bent and extends from an edge of the top plate 121 toward the base 102. The plurality of electronic elements 140, the pins 151 of the plurality of first connection terminals 150, the pins 161 of the plurality of second connection terminals 160, and the solder 175 may be accommodated in an inner space of the cover 120 defined by the top plate 121 and the skirt 123.

In order for the cover 120 to be detachably coupled to the base 102, the base 102 may include a pair of hook receivers 113 formed in the pair of sidewalls 110, and the cover 120 may include a pair of hooks 125 that are detachably coupled to the pair of hook receivers 113. The pair of hooks 125 may protrude downward from the skirt 123 (e.g., toward the base 120). In some examples, in an electronic element assembly, unlike as illustrated in FIGS. 4 and 5, the hook receiver may be provided on the cover and the hook may be provided on the base.

The circuit board pusher 128 may be formed to protrude downward from the top plate 121 (e.g., toward the base 120). In some examples, a plurality of circuit board pusher 128 may be provided. The circuit board pusher 128 presses the circuit board 130 toward the base 102 such that the plurality of first connection terminals 150 are connected to the ends 65 of the plurality of first electrical wires 63 and the plurality of second connection terminals 160 are connected to the ends 75 of the plurality of second electrical wires 73.

Accordingly, when the cover 120 is coupled to the base 102, the forks 153 of the plurality of first connection terminals 150 and the forks 163 of the plurality of second connection terminals 160 may be concurrently (e.g., simultaneously) inserted into the plurality of electrical wire entry holes 108, so that the plurality of first connection terminals 150 and the plurality of first electrical wires 63 are connected, and the plurality of second connection terminals 160 and the plurality of second electrical wires 73 are connected.

The circuit board support protrusion 124 may support the circuit board 130 to prevent the circuit board 130 from being separated from the cover 120. The circuit board support protrusion 124 may be provided as a pair. The pair of circuit board support protrusions 124 may protrude from the pair of hooks 125. Accordingly, when the cover 120 is separated and spaced apart from the base 102, the circuit board 130 and the plurality of first connection terminals 150 and the plurality of second connection terminals 160 coupled thereto may be separated and spaced apart from the base 102 together with the cover 120.

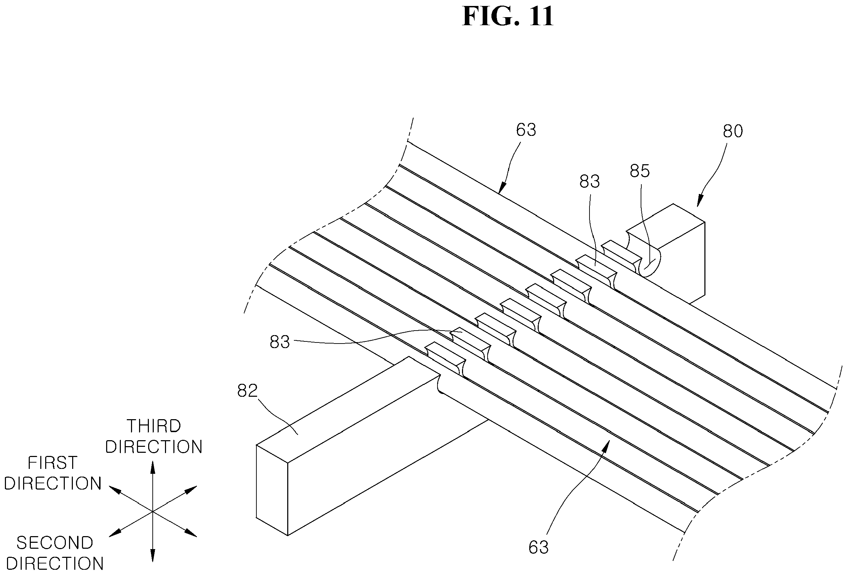

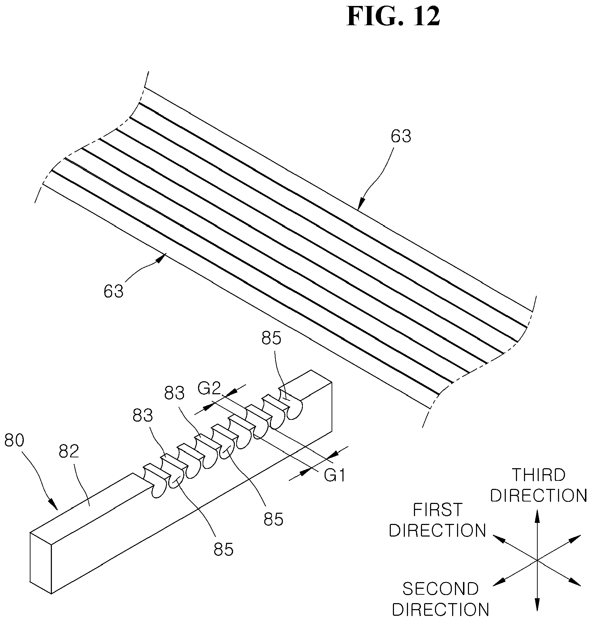

FIG. 11 is a perspective view illustrating a wire holder in FIG. 3 and electrical wires supported on the wire holder according to some embodiments of the present invention, and FIG. 12 is a view illustrating the wire holder in FIG. 11 separated from the electrical wires, according to some embodiments of the present invention. With reference to FIGS. 11 and 12, the battery module 10 may further include a wire holder 80 that is installed on the busbar holder 40.

The wire holder 80 may be supported on the holder plate 41. A plurality of wire fitting grooves 85 may be formed in which the plurality of first electrical wires 63 may be fitted and supported one by one on a top surface 82, which is a side surface opposite to a side surface of the wire holder 80 supported on the holder plate 41. Each of the plurality of wire fitting grooves 85 is open upward to allow the first electrical wire 63 to be fitted therein.

The width G2 of an opening of the wire fitting groove 85 that opens upward may be slightly smaller than the diameter of the first electrical wire 63. Inside the wire fitting groove 85, the maximum width G1 of the wire fitting groove 85 may be slightly greater than the diameter of the first electrical wire 63. Accordingly, the first electrical wires 63 may be fitted into the wire fitting grooves 85 one by one to be seated and may not accidentally fall out through the opening on the upper side of the wire fitting grooves 85. A spacer 83 that separates a neighboring pair of first electrical wires 63 by an appropriate distance may be provided between a neighboring pair of wire fitting grooves 85.

According to some embodiments of the present invention, when sensors included in a battery module are connected to a connector with a plurality of electrical wires, for example, an electronic element such as a fuse can be easily and quickly connected to the electrical wires.

According to some embodiments of the present invention, because an electronic element and electrical wires in the battery module are neatly arranged without bunching or tangling, it is easy to reduce (e.g., minimize) the size of the battery module, the production cost of the battery module can be reduced, and the manufacturing productivity of the battery module can be improved (e.g., increased).

Although the present invention has been described with reference to embodiments and drawings illustrating aspects thereof, the present invention is not limited thereto.

## Claims

1. An electronic element assembly (100) comprising:
a circuit board (130);
an electronic element (140) mounted on the circuit board (130);
a plurality of first connection terminals (150) coupled to the circuit board (130) and configured to be electrically connected to the electronic element (140), and the plurality of first connection terminals (150) being electrically connected to a plurality of first electrical wires (63); and
a plurality of second connection terminals (160) coupled to the circuit board (130) and configured to be electrically connected to the electronic element (140), and the plurality of second connection terminals (160) electrically connected to a plurality of second electrical wires (73) spaced apart from the plurality of first electrical wires (63).

2. The electronic element assembly (100) of claim 1, further comprising: a case configured to accommodate the circuit board (130), the electronic element (140), the plurality of first connection terminals (150), and the plurality of second connection terminals (160), the case having a plurality of electrical wire entry holes (108) formed therein and into which ends (65) of the plurality of first electrical wires (63) and ends (65) of the plurality of second electrical wires (73) are configured to be inserted.

3. The electronic element assembly (100) of claim 2, wherein the case comprises:
a base (102) having the plurality of the electrical wire entry holes (108) formed therein; and
a cover (120) detachably coupled to the base (102) and configured to cover the circuit board (130), the electronic element (140), the plurality of first connection terminals (150), and the plurality of second connection terminals (160).

4. The electronic element assembly (100) of claim 3, wherein the cover (120) comprises: a circuit board pusher (128) configured to press the circuit board (130) such that the plurality of first connection terminals (150) are connected to the plurality of first electrical wires (63) and the plurality of second connection terminals (160) are connected to the plurality of second electrical wires (73).

5. The electronic element assembly (100) of claim 3 or 4, wherein the cover (120) comprises: a circuit board support protrusion (124) configured to support the circuit board (130) such that the circuit board (130) is not separated from the cover (120).

6. The electronic element assembly (100) of any of claims 3 to 5, wherein one of the base (102) and the cover (120) comprises a hook receiver, and the other of the base (102) and the cover (120) comprises a hook detachably coupled to the hook receiver.

7. The electronic element assembly (100) of any of claims 1 to 6, wherein each of the first electrical wire (63) and the second electrical wire (73) comprises: a core (67, 77) formed of a conductor configured to conduct current and a sheath (68, 78) formed of an insulator and surrounding the core (67, 77), and
wherein each of the first connection terminal (150) and the second connection terminal (160) comprises a fork (153, 163) configured to cut the sheath (68, 78) and to electrically coming into contact with the core (67, 77).

8. The electronic element assembly (100) of claim 7, wherein the electronic element (140) is mounted on one side surface of the circuit board (130), and the fork (153, 163) protrudes from the other side surface of the circuit board (130).

9. The electronic element assembly (100) of any of claims 1 to 8, wherein the electronic element (140) comprises a plurality of fuses configured to be connected to the plurality of first connection terminals (150) and the plurality of second connection terminals (160).

10. A battery module (10) comprising:
a plurality of battery cells (11);
a plurality of sensors (60) configured to detect a state of the plurality of battery cells (11);
a plurality of first electrical wires (63) electrically connected to the plurality of sensors (60);
a plurality of second electrical wires (73) spaced apart from the plurality of first electrical wires (63) and electrically connected to a connector (70, 71); and
an electronic element assembly (100) configured to electrically connect the plurality of first electrical wires (63) and the plurality of second electrical wires (73) and comprising a circuit board (130), an electronic element (140) mounted on the circuit board (130), a plurality of first connection terminals (150) coupled to the circuit board (130) and configured to be electrically connected to the electronic element (140) and the plurality of first electrical wires (63), and a plurality of second connection terminals (160) coupled to the circuit board (130) and configured to be electrically connected to the electronic element (140) and the plurality of second electrical wires (73).

11. The battery module (10) of claim 10, wherein the electronic element assembly (100) further comprises: a case configured to accommodate the circuit board (130), the electronic element (140), the plurality of first connection terminals (150), and the plurality of second connection terminals (160), the case having a plurality of electrical wire entry holes (108) formed therein and into which ends (65) of the plurality of first electrical wires (63) and ends (65) of the plurality of second electrical wires (73) are configured to be inserted.

12. The battery module (10) of claim 10 or 11, wherein each of the first electrical wire (63) and the second electrical wire (73) comprises: a core (67, 77) formed of a conductor configured to conduct current, and a sheath (68, 78) formed of an insulator and surrounding the core (67, 77), and
wherein each of the first connection terminal (150) and the second connection terminal (160) comprises a fork (153, 163) configured to cut the sheath (68, 78) and to electrically coming into contact with the core (67, 77).

13. The battery module (10) of any of claims 10 to 12, further comprising:
a cell connection busbar (50) configured to electrically connect a neighboring pair of battery cells (11) of the plurality of battery cells (11); and
a busbar holder (40) configured to support the cell connection busbar (50) and on which the electronic element assembly (100) is installed.

14. The battery module (10) of claim 13, wherein each of the battery cells (11) comprises a cell vent (14) through which gas is discharged from an inside of the battery cell (11) to an outside of the battery cell (11),
wherein the busbar holder (40) has a plurality of vent through-holes (45) corresponding to the plurality of cell vents (14) formed therein, and
wherein the electronic element assembly (100) is positioned between a neighboring pair of vent through-holes (45) of the plurality of the vent through-holes.

15. The battery module (10) of any of claims 10 to 14, further comprising: a wire holder (80) in which a plurality of wire fitting grooves (85) are formed the plurality of first electrical wires (63) being configured to fit within and be supported by the wire fitting grooves (85), the wire holder (80) being on the busbar holder (40).
